# EUROPÄISCHE PATENTSCHRIFT

(11) **EP 1 393 154 B1**
(45) Veröffentlichungstag und Bekanntmachung des Hinweises auf die Patenterteilung: **20.11.2013**
(21) Anmeldenummer: 02735330.9
(22) Anmeldetag: 03.05.2002
(51) Int. Cl.: G01R 1/02, G06F 3/023, G01D 1/00, G01R 31/28

(54) **MESSGERÄT MIT DIALOGBEDIENUNG ÜBER DIALOGFENSTER UND ENTSPRECHENDES VERFAHREN**
MEASURING DEVICE WITH DIALOG CONTROL OCCURRING VIA DIALOG WINDOWS AND CORRESPONDING METHOD
APPAREIL DE MESURE A COMMANDE DE DIALOGUE PAR FENETRE DE DIALOGUE ET PROCEDE CORRESPONDANT

(30) Priorität: 18.05.2001 DE 10124371; 10.08.2001 DE 10139491
(43) Veröffentlichungstag der Anmeldung: 03.03.2004
(73) Patentinhaber: Rohde & Schwarz GmbH & Co. KG, 81671 München (DE)
(72) Erfinder: RIEGER, Angela, 80687 München (DE); LAINER, Kurt, 85551 Kirchheim bei München (DE); REIFERT, Bernhard, 84453 Mühldorf (DE); ILLICH, Valentin, 81245 München (DE); THOMA, Sebastian, 83026 Rosenheim (DE)
(74) Vertreter: Körfer, Thomas
(86) Internationale Anmeldenummer: PCT/EP2002/004889
(87) Internationale Veröffentlichungsnummer: WO 2002/095565

(56) Entgegenhaltungen:
- EP-A- 0 548 646
- EP-A- 1 008 932
- EP-A1- 0 858 016
- DE-A- 3 618 256
- DE-A1- 19 515 198
- GB-A- 2 256 954
- US-A- 4 634 970
- US-A- 5 321 420
- PATENT ABSTRACTS OF JAPAN vol. 1999, no. 13, 30. November 1999 (1999-11-30) & JP 11 212754 A (HITACHI LTD;HITACHI KEIYO ENG CO LTD), 6. August 1999 (1999-08-06)

## Beschreibung

Die Erfindung betrifft ein Meßgerät mit einer Dialogbedienung über Dialogfenster zur Einstellung von Einstellparameter der Funktionseinheiten des Meßgeräts sowie ein Verfahren zur Verwaltung der Dialogfenster und ein Computerprogramm zur Durchführung der Verfahrensschritte.

Zur Bedienung von Meßgeräten ist es üblich, die Auswahl von Funktionen über Bedientasten vorzunehmen. Nach erfolgter Auswahl einer Funktion ist der Wert eines Einstellparameters, der der entsprechenden Funktion zugeordnet ist, durch Betätigen eines Drehknopfs veränderbar. Bei mehreren möglichen Einstellparametern, die bezüglich derselben Funktion zu einem Parametersatz zusammenwirken, ist die Auswahl der einzelnen Einstellparameter durch eine entsprechende Anzahl Bedientasten nacheinander erforderlich, so daß ein vollständiger Parametersatz abgearbeitet werden muß. Bei einem Meßgerät mit einer umfassenden Funktionalität und einer dementsprechend hohen Anzahl von Einzelfunktionen und zugeordneten Einstellparametern ist eine Vielzahl von Bedientasten oder eine Mehrfachbelegung einzelner Bedientasten die Folge.

Sowohl eine hohe Anzahl von Bedientasten als auch eine Mehrfachbelegung führen dabei mit zunehmender Komplexität der funktionalen Struktur zu einer Unübersichtlichkeit, die die Bedienung des Meßgeräts im Praxiseinsatz erheblich erschwert. Insbesondere ist ein schneller Überblick über beispielsweise alle zu einer bestimmten Funktion gehörenden Einstellparameter nicht möglich.

Zum technischen Hintergrund sei noch auf die US 5,953,009 verwiesen. Aus dieser Druckschrift geht die Zuweisung von Trigger-Funktionen an einem Meßkanal eines digitalen Oszilloskops durch Anklicken und Verschieben von die Trigger-Funktionen symbolisierenden Ikonen auf der Bedienoberfläche hervor. Der Signalfluß einzelner Funktionseinheiten und die Funktion dieser Funktionseinheiten sind auf der Bedienoberfläche jedoch nicht erkennbar und können auf der Bedienoberfläche nicht ausgewählt werden.

Aus der US 5,321,420 A ist ein Messgerät bekannt, welches verschiedene Dialogfenster auf einer Bildschirmeinheit darstellt, wobei bei Auswahl eines Dialogfensters, die verschiedenen Funktionen des Dialogfensters verschiedenen Softkeytasten zugewiesen werden. Die aktuelle Belegung der Softkeytasten wird dabei durch Ikonen dargestellt, die oberhalb der Softkeytasten auf der Bildschirmeinheit angeordnet sind.

Der Erfindung liegt die Aufgabe zugrunde, ein Meßgerät mit einer übersichtlichen dialoggeführten Bedienung sowie ein entsprechendes Verfahren und Computerprogramm zu schaffen.

Die Aufgabe wird durch das erfindungsgemäße Meßgerät mit den Merkmalen des Anspruchs 1, das erfindungsgemäße Verfahren mit den Merkmalen des Anspruchs 9 sowie das erfindungsgemäße Computerprogramm mit den Merkmalen des Anspruchs 15 oder 16 gelöst.

Bei dem Konzept der dialoggeführten Bedienung des erfindungsgemäßen Meßgeräts, ist durch das zusammengefaßte Darstellen von Einstellparametern in Dialogfenstern für den Benutzer des Meßgeräts eine große Transparenz bezüglich der vorgenommenen Einstellungen gewährleistet. Durch die Belegung von Softkeytasten ist dabei jeweils ein Dialogfenster im Vordergrund darstellbar, so daß die Gesamtheit eines Satzes von Einstellparametern einer Funktionseinheit, auf einen Blick zu erfassen ist. Dabei ist die jeweils aktuelle Belegung der Softkeytasten z.B. in einem Fensterverwaltungsstreifen der Darstellungseinrichtung angezeigt, so daß für den Bediener eine intuitive Bedienung mehrerer Dialogfenster möglich ist.

Durch die in den Unteransprüchen aufgeführten Maßnahmen sind vorteilhafte Weiterbildungen des erfindungsgemäßen Meßgeräts bzw. des erfindungsgemäßen Verfahrens möglich.

Ein Ausführungsbeispiel der Erfindung wird nachfolgend unter Bezugnahme auf die Zeichnung näher beschrieben. In der Zeichnung zeigen:
- Fig. 1: ein Blockschaltbild eines Ausführungsbeispiels eines als erfindungsgemäßes Meßgerät ausgebildeten Signalgenerators;
- Fig. 2: ein Beispiel einer Ansicht der Darstellungseinrichtung mit als Funktionsblöcken dargestellten Funktionseinheiten des Meßgeräts;
- Fig. 3: ein erstes Beispiel einer Ansicht einer Frontplatte des Signalgenerators mit einem geöffneten Dialogfenster; und
- Fig. 4: ein zweites Beispiel einer Ansicht einer Frontplatte des Signalgenerators mit mehreren geöffneten Dialogfenstern.

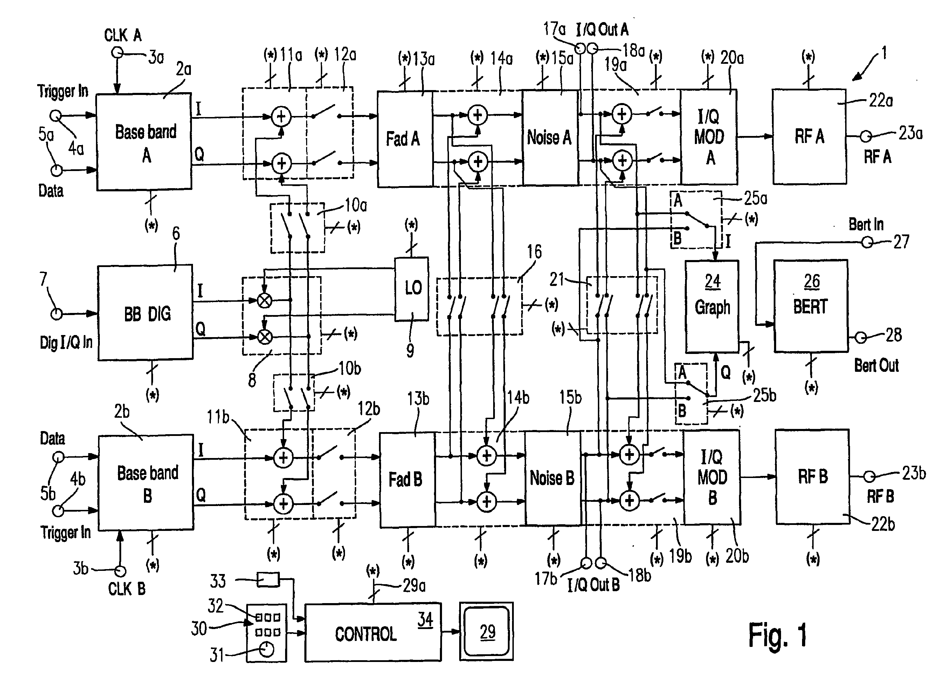

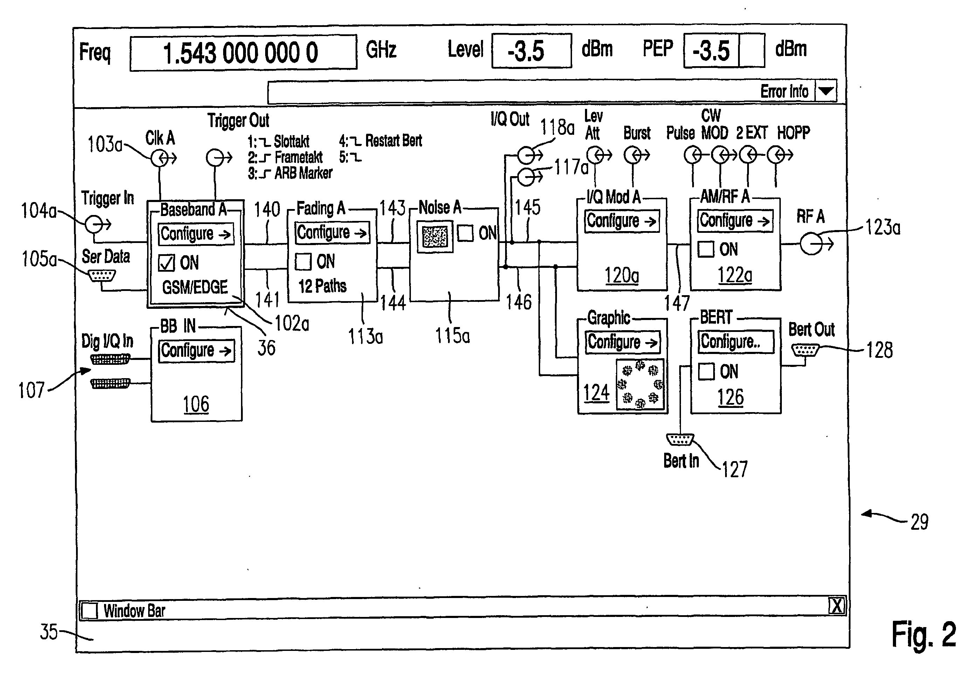

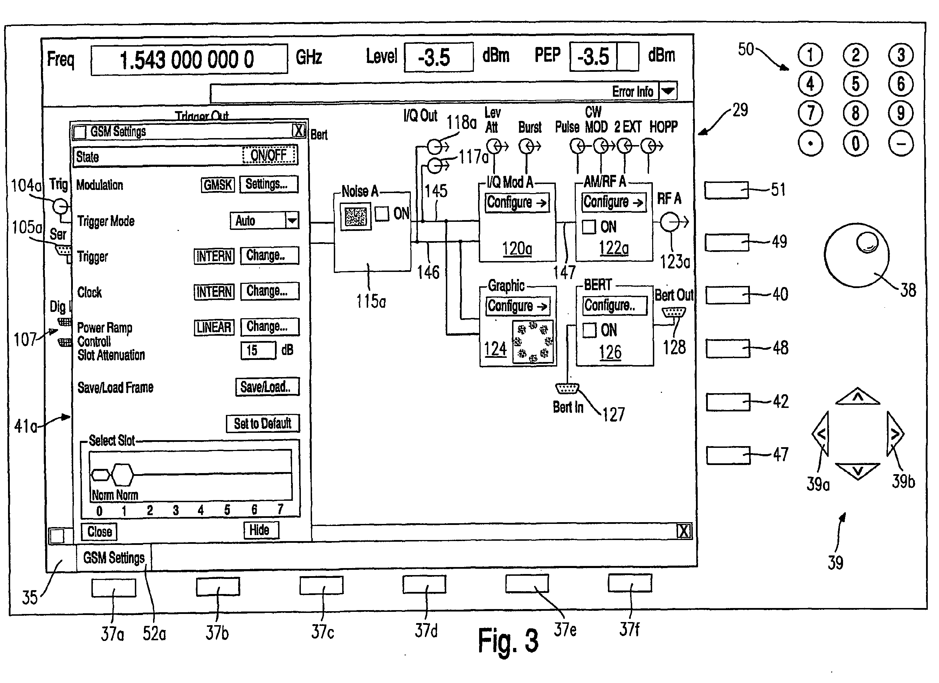

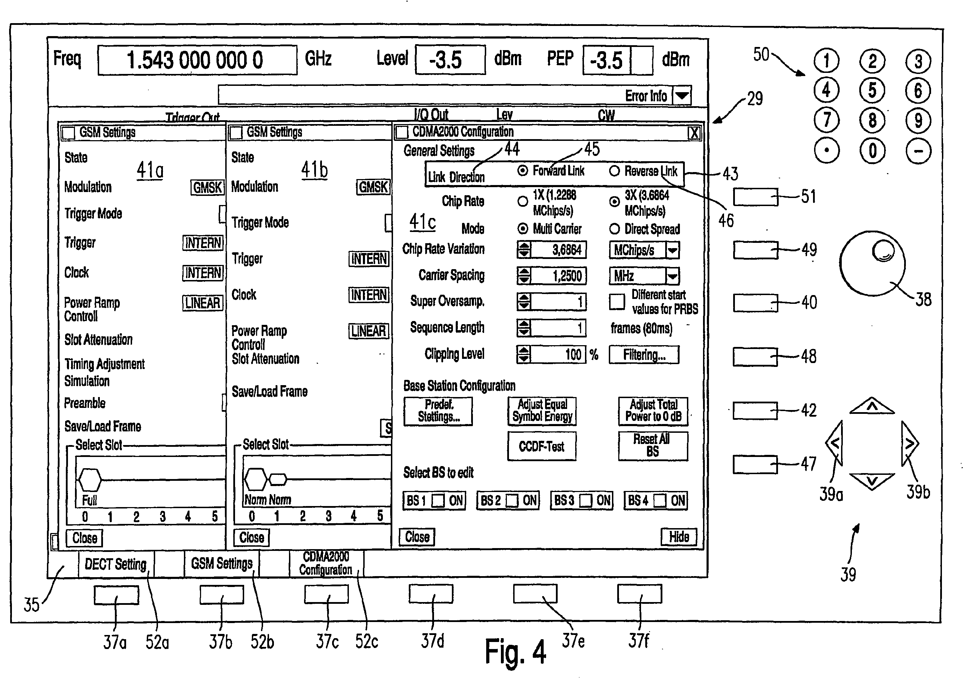

Bevor anhand der Figuren 3 und 4 Ausführungsbeispiele der graphischen Darstellung sowie die Verwaltung von Dialogfenstern beschrieben werden, wird zunächst anhand von Fig. 1 ein Blockschaltbild eines Signalgenerators beschrieben, der als erfindungsgemäßes Meßgerät 1 ausgebildet ist, und anhand von Fig. 2 ein Beispiel auf der Darstellungseinrichtung dargestellter Funktionsblöcke erläutert. Das Meßgerät ist nicht zwingend ein Signalgenerator, es kann auch ein Protokolltester oder Spektrumanalysator sein.

Der Signalgenerator umfaßt eine erste Basisbandeinheit 2a und eine zweite Basisbandeinheit 2b. Die Basisbandeinheiten 2a und 2b erzeugen an ihren I- und Q-Ausgängen Basisbandsignale nach vorgegebenen, durch den Benutzer auswählbaren Standards, beispielsweise nach dem GSM-Standard, dem GSM-EDGE-Standard oder einem Weitband-CDMA-Standard. Den Basisbandeinheiten 2a, 2b sind an Buchsen 3a bzw. 3b Clock-Signale, an Buchsen 4a bzw. 4b Trigger-Signale und an Buchsen 5a bzw. 5b Modulationsdaten zuführbar. Daneben ist im dargestellten Ausführungsbeispiel eine digitale Basisbandgeneratoreinheit 6 vorhanden, die aus an einer Buchse 7 zugeführten digitalen I/Q-Werten die I- und Q-Komponente eines weiteren Basisband-Signals erzeugt. Das Ausgangssignal des digitalen Basisbandgenerators 6 kann in einer Multipliziereinheit 8, welcher die konstante Frequenz eines einstellbaren lokalen Oszillators 9 zugeführt wird, hochgesetzt werden.

Über eine Schalteinheit 10a bzw. eine zweite Schalteinheit 10b wird das ggf. hochgemischte Basisbandsignal der digitalen Basisbandgeneratoreinheit 6 einer digitalen Addiereinheit 11a oder einer digitalen Addiereinheit 11b zugeführt.

Über eine Schalteinheit 12a bzw. eine Schalteinheit 12b wird das Ausgangssignal der Basisbandeinheiten 2a und 2b bzw. der Addiereinheiten 11a und 11b einer Fadingeinheit 13a bzw. 13b zugeführt, die das Basisbandsignal mit einem Fading (variablem Schwund) beaufschlagt. Die Funktionen der Fadingeinheiten 13a und 13b, beispielsweise die Anzahl, die Zeitverzögerung und die Dämpfung der in der Fadingeinheit implementierten Signalverzögerungspfade, können durch den Benutzer festgelegt werden. Die Fadingeinheiten 13a und 13b sind über jeweils eine Addiereinheit 14a bzw. 14b mit jeweils einer Rauscheinheit 15a bzw. 15b verbunden. Die Rauscheinheiten 15a, 15b beaufschlagen das Basisbandsignal mit einem durch den Benutzer festlegbaren Rauschsignal, wobei beispielsweise die Rauschart und der Pegel des von der Rauscheinheit 15a, 15b erzeugten Rauschsignals durch den Benutzer auswählbar ist.

Über eine die Addiereinheiten 14a und 14b verbindende Schalteinheit 16 können anstatt einer separaten Verbindung der jeweiligen Fadingeinheit 13a bzw. 13b mit der zugeordneten Rauscheinheit 15a bzw. 15b die Ausgangssignale der Fadingeinheiten 13a, 13b auch addiert und jeweils einer der beiden Rauscheinheiten 15a bzw. 15b zugeführt werden.

Die I/Q-Ausgangssignale am Ausgang der Rauscheinheiten 15a bzw. 15b sind an Buchsen 17a und 18a bzw. 17b und 18b auskoppelbar.

Die Ausgangssignale der Rauscheinheiten 17a und 17b sind über Addier- und Schalteinheiten 19a und 19b I/Q-Modulatoren 20a bzw. 20b zuführbar. Auch hier besteht über eine Schalteinheit 21 die Möglichkeit, die Ausgangssignale der Rauscheinheiten 15a und 15b zu addieren und einem der beiden I/Q-Modulatoren 20a bzw. 20b zuzuführen. Auch hinsichtlich der Funktion des I/Q-Modulators 20a, 20b bestehen mehrere benutzerspezifische Auswahlmöglichkeiten. Beispielsweise kann der I/Q-Modulator 20a, 20b so betrieben werden, daß dieser eine Burst-Sequenz erzeugt und die aktiven Bursts bzw. die Pegel der aktiven Bursts durch die Benutzer ausgewählt werden können.

Die I/Q-Modulatoren 20a und 20b sind jeweils mit einer Hochfrequenzeinheit 22a bzw. 22b verbunden und das Hochfrequenzsignal kann an einer Buchse 23a bzw. 23b abgenommen werden. Beispielsweise können die Ausgangsfrequenz oder mehrere im Frequenzsprungverfahren angesprungene Ausgangsfrequenzen der Hochfrequenzeinheit 22a und 22b durch den Benutzer ausgewählt werden.

Zusätzlich ist eine Signalanzeige 24 vorhanden, die über Schalteinheiten 25a bzw. 25b im Ausführungsbeispiel mit dem Ausgang der Rauscheinheit 15a oder der Rauscheinheit 15b verbindbar ist. Alternativ ist es auch denkbar, daß die Anzeigeeinrichtung 24 direkt mit den Ausgängen der Basisbandeinheiten 2a und 2b verbindbar ist. Die Signalanzeige 24 ermöglicht beispielsweise die Darstellung des Konstellationsdiagramms, so daß der Benutzer die Wirkungsweise des geschalteten Signalpfads überprüfen kann.

Ferner ist ein Bitfehlerratentester (BERT = Bit Error Rate Tester) 26 vorgesehen, dessen Eingangsbuchse 27 ein Signal des Prüflings (DUT) zuführbar ist, wobei an der Ausgangsbuchse 28 die Bitfehlerrate des Signals abgenommen werden kann.

Es können auch noch weitere Funktionseinheiten vorhanden sein und es können weitere Kombinationsvarianten der Funktionseinheiten möglich sein, die aufgrund der Übersichtlichkeit nicht dargestellt sind.

Alle vorstehend beschriebenen Funktionseinheiten 2a, 2b, 6, 8, 9, 10a, 10b, 11a, 11b, 12a, 12b, 13a, 13b, 14a, 14b, 15a, 15b, 16, 19a, 19b, 20a, 20b, 21, 22a, 22b, 24 und 26 sind mit einer Steuereinrichtung 34, beispielsweise einer CPU, über einen Steuerbus 29a, dessen Verbindung mit den Funktionseinheiten über das Symbol (*) gekennzeichnet ist, verbunden. Die Steuereinheit 34 steuert die vom Benutzer gewünschte Verschaltung und Funktion der einzelnen Funktionseinheiten. Die aktuelle Verschaltung der Funktionseinheiten wird auf einer Darstellungseinrichtung (einem Display) 29, das sich zusammen mit den Bedienelementen 30 an der Frontplatte des Meßgeräts 1 befinden kann, dargestellt. Dazu ist jeder Funktionseinheit ein graphischer Funktionsblock zugeordnet und die Verbindung der Funktionseinheiten wird durch entsprechende Verbindungselemente, die die Funktionsblöcke miteinander verbinden, auf der Darstellungseinrichtung 29 dargestellt. Die Auswahl der Verbindungen der Funktionsblöcke und die Auswahl der Funktionen der Funktionsblöcke erfolgt entweder mittels eines Drehknopfs 38 und/oder entsprechenden Bedienknöpfen 32, z.B. Drucktasten, oder über ein verfahrbares Positionierungselement 33 (Maus).

Fig. 2 zeigt die Darstellungsoberfläche der Darstellungseinrichtung (Display) 29 eines ersten Funktionsbeispiels des als Signalgenerator ausgebildeten Meßgeräts 1. Erkennbar ist, daß den anhand von Fig. 1 beschriebenen Funktionseinheiten auf der Darstellungseinrichtung 29 dargestellte Funktionsblöcke entsprechen. Die Bezugszeichen der Funktionsblöcke sind jeweils um 100 gegenüber den Bezugszeichen der in Fig. 1 dargestellten Funktionseinheiten erhöht. In Fig. 2 ist ein erster Basisbandblock 102a entsprechend der ersten Basisbandeinheit 2a, ein erster Fadingblock 113a entsprechend der ersten Fadingeinheit 13a und ein erster Rauschblock 115a entsprechend der ersten Rauscheinheit 15a, ein erster I/Q-Modulator-Block 120a entsprechend dem ersten I/Q-Modulator 20a, ein erster Hochfrequenzblock 122a entsprechend der ersten Hochfrequenzeinheit 22a, ein Anzeigebereich 124 entsprechend der Signalanzeige 24 und ein Bitfehlerratentest-Block 126 und entsprechend dem Bitfehlerraten-Tester 26 als Funktionsblöcke dargestellt. Dabei entsprechen die Signal- und Daten- Ein- und Ausgänge 103a, 104a, 105a, 107, 117a, 118a, 123a, 127 und 128 den in Fig. 1 dargestellten Buchsen 3a, 4a, 5a, 7, 17a, 18a, 23a, 27 und 28.

Der Benutzer erkennt durch Blick auf die Darstellungseinrichtung 29 (das Display) die bezüglich der aktuellen Funktionen des Meßgeräts 1 ausgewählten und zusammengeschalteten Funktionseinheiten anhand der dargestellten Funktionsblöcke, die diesen Funktionseinheiten entsprechen. Ferner ist sofort erkennbar, welche Ein- und Ausgänge in welcher Weise mit Signalen belegt sind. Der interne Signalfluß und somit die Signalaufbereitung sind für den Benutzer sehr transparent dargestellt. Beispielsweise ist erkennbar, daß die Fadingeinheit 13a vor der Rauscheinheit 15a angeordnet ist, ob das Bursting des Signals im Basisband oder in der Hochfrequenz durchgeführt wird und an welchen Buchsen externe Signale angelegt werden können und wie diese auf den Signalfluß einwirken. Insbesondere wird für den Benutzer sofort erkennbar, ob eine Buchse als Ein- oder Ausgang wirkt. In den Funktionsblöcken sind die aktuellen Konfigurationen erkennbar. Besonders wichtige Parameter sind direkt in den Funktionsblöcken angezeigt. Außerdem ist für den Benutzer verdeutlicht, an welcher Stelle die Signalanzeige 24 in den Signalpfad geschaltet ist.

Wird der durch einen in der Fig. 2 schwarz dargestellten Markierungsrahmen (Markierung) 36 markierte Funktionsblock 102a selektiert, so wird nach Vorauswahl beispielsweise des "GSM/EDGE" Standards über eine Funktionsauswahlliste ein in Fig. 3 gezeigtes Dialogfenster 41a auf der Darstellungseinrichtung 29 im Vordergrund dargestellt. Es ist zu unterscheiden zwischen einem offenen Dialog und einem Dialogfenster, da ein Dialog auch dann offen sein kann, wenn das entsprechende Dialogfenster auf der Darstellungseinrichtung gerade nicht dargestellt wird. Es erfolgt daher zusätzlich zum Öffnen des Dialogfensters 41a ein Eintrag des offenen Dialogs in einem Fensterverwaltungsstreifen 35. Der Eintrag in den Fensterverwaltungsstreifen 35, der durch eine den geöffneten Dialog darstellende Ikone 52a optisch dargestellt ist, ordnet einer Bedientaste den offenen Dialog als Softkey zu, so daß der Dialog über die so belegte Softkeytaste 37a aufrufbar ist und das Dialogfenster 41a des aufgerufenen Dialogs wieder im Vordergrund der Darstellungseinrichtung 29 dargestellt wird. Zum Erleichtern einer intuitiven Bedienung ist die Ikone 52a des Eintrags der Position der Softkeytaste 37a zugeordnet.

Der Markierungsrahmen bzw. die Markierung 36, mit dem bzw. der ein Funktionsblock markierbar ist, läßt sich durch Drehen eines als Drehknopf 38 ausgebildeten Positionierungselements in vertikaler Richtung verschieben. Bei Anordnung mehrerer in horizontaler Richtung benachbarter Funktionsblöcke wird die Funktionalität des Drehknopfs 38 durch die Richtungstasten 39 erweitert, so daß ein Wechsel des Markierungsrahmens 36 von einem Funktionsblock zu einem horizontal benachbarten Funktionsblock mittels der linken und rechten Richtungstaste 39a und 39b erfolgt. Nach Verschieben des Markierungsrahmens 36 auf denjenigen Funktionsblock 102a, dessen Einstellparameter zu ändern sind, wird der Funktionsblock 102a durch Betätigen einer Auswahleinrichtung selektiert. Die Auswahleinrichtung kann beispielsweise als Eingabetaste 40 oder als Drucktaster in dem Drehknopf 38 ausgebildet sein. Wird das Meßgerät 1 nicht in eine Aufnahmevorrichtung eingebaut, sondern als Tischgerät verwendet, ist auch eine Bedienung über das verfahrbare Positionierungselement 33 (Maus) möglich.

Um bei einem im Vordergrund der Darstellungseinrichtung 29 dargestellten Dialogfenster 41a wieder zu der Darstellung der Funktionsblöcke zurückkehren zu können, ist das Dialogfenster 41a durch eine bestimmte Bedientaste ("Hintergrund") 42 in den Hintergrund der Darstellungseinrichtung 29 zu bringen. Der eigentliche Dialog bleibt dabei weiterhin offen, so daß auch der Eintrag in dem Fensterverwaltungsstreifen 35 erhalten bleibt und das Dialogfenster 41a über die Softkeytaste 37a wieder in den Vordergrund gebracht werden kann. In der nunmehr wieder vollständig sichtbaren Darstellung der Funktionsblöcke wie in Fig. 2 ist entsprechend der vorstehenden Beschreibung ein neuer Funktionsblock markierbar und selektierbar.

Eine beispielhafte Darstellung einer Frontplatte des Meßgeräts 1 mit mehreren gleichzeitig auf einer Darstellungseinrichtung 29 angezeigten Dialogfenstern 141a bis 41c ist in Fig. 4 dargestellt. Weitere Dialogfenster 41b und 41c sind analog zu dem ersten Dialogfenster 41a zu öffnen, wobei den neu geöffneten Dialogfenstern 41b und 41c je eine noch nicht belegte Softkeytaste 37b und 37c zugeordnet wird. Die Zuordnung der neuen Dialogfenster 41b und 41c wird in dem Fensterverwaltungsstreifen 35 als neue Einträge gespeichert und optisch entsprechende neue Ikonen 52b und 52c dargestellt.

Aufgrund der beschränkten Fläche der Darstellungseinrichtung 29 werden die sich öffnenden Dialogfenster 41a bis 41c sich überlappend dargestellt. Die Position an der jedes neue Dialogfenster öffnet, ist vorgegeben, wobei bei der Positionsvorgabe die Anzahl der bereits geöffneten Dialogfenster 41a bis 41c berücksichtigt wird, so daß jedes nicht durch die "Hintergrund"-Bedientaste 42 vollständig in den Hintergrund gebrachte Dialogfenster 41a, 41b nur teilweise sichtbar ist. In der Darstellung wird dies durch die Dialogfenster 41a und 41b gezeigt, wohingegen das aktive Dialogfenster 41c vollständig sichtbar im Vordergrund dargestellt ist.

Die Änderung von Einstellparametern ist jeweils für diejenigen Parameter möglich, die sich in dem aktiven Dialogfenster befinden. In der Fig. 4 ist das Dialogfenster 41c aktiv und daher vollständig im Vordergrund sichtbar. Ein Wechsel zu einem anderen Dialogfenster 41a oder 41b als aktivem Dialogfenster ist durch Drücken der entsprechenden Softkeytaste 37a oder 37b möglich. Das neue aktive Dialogfenster 41a oder 41b wird dann vollständig im Vordergrund der Darstellungseinrichtung 29 dargestellt und das dann nicht mehr aktive Dialogfenster 41c wird teilweise überdeckt.

Die Auswahl eines zu ändernden Einstellparameters innerhalb des aktiven Dialogfensters 41c erfolgt über einen Bedienfokus 43, der in der Darstellung als Umrahmung der zu einem Bedienblock gehörenden Bedienelemente 44, 45 und 46 angezeigt wird. Die Bedienelemente 44, 45 und 46 umfassen im dargestellten Beispiel den Namen des Einstellparameters als Bedienelement 44, sowie die beiden dem Einstellparameter zugeordneten Einstellmöglichkeiten als Bedienelemente 45 und 46. Der Bedienfokus 43 ist durch den Drehknopf 38 und die Richtungstasten 39 innerhalb des aktiven Dialogfensters 41c navigierbar bzw. verschiebar.

Bei dem in der Fig. 4 dargestellten Meßgeräts 1 ist durch die Anzahl der Softkeytasten 37a bis 37f eine maximal mögliche Anzahl von im Beispiel sechs gleichzeitig offenen Dialogen vorgegeben. Die Öffnung eines weiteren Dialogs erfordert das Schließen eines Dialogs, also das Schließen eines Dialogfensters und das Löschen des zugeordneten Eintrags aus dem Fensterverwaltungsstreifen 25. Hierzu stehen dem Benutzer zwei unterschiedliche Wege offen.

Durch Drücken einer Softkeytaste 37a bis 37f kann der Benutzer ein Dialogfenster, das den zu schließenden Dialog betrifft in den Vordergrund bringen. Das dann aktive Dialogfenster ist über eine als Hardkey ausgeführte Bedientaste ("Schließen") 47 zu schließen. Gleichzeitig mit dem Schließen z.B. des Dialogfensters 41b wird der der Softkeytaste 37b zugeordnete Eintrag in dem Fensterverwaltungsstreifen 35 gelöscht. Bei Öffnen eines neuen Dialogfensters ist somit die Softkeytaste 37b frei und wird mit dem Eintrag des neu zu öffnenden Dialogs belegt.

Sind dagegen alle Softkeytasten 37a bis 37f belegt, wenn durch den Benutzer ein neuer Dialog geöffnet wird, so wird automatisch ein Dialog ausgewählt, dessen Dialogfenster dann geschlossen wird und dessen zugehöriger Eintrag aus dem Fensterverwaltungsstreifen 35 gelöscht wird. Die Auswahl des zu schließenden Dialogs erfolgt vorzugsweise über einen Vergleich der Zeitdauer, in der die geöffneten Dialogfenster nicht mehr aktiv waren. Dasjenige Dialogfenster, welches am längsten nicht mehr im Vordergrund dargestellt war, wird beispielsweise ausgewählt und der Dialog automatisch geschlossen.

Durch die wechselnde Anzahl darzustellender Dialogfenster kann es erforderlich sein, die Verteilung der Dialogfenster neu zu gestalten. Hierzu ist eine weitere Bedientaste ("Anordnen") 48 vorgesehen, mit der die zum Zeitpunkt des Tastendrucks im Vordergrund der Darstellungseinrichtung 29 dargestellten Dialogfenster 41a bis 41c gleichmäßig über die gesamte Breite der Darstellungseinrichtung 29 angezeigt werden. In Fig. 4 ist eine solche optimierte Anzeige dargestellt.

Die als Hardkey ausgeführten "Hintergrund"-Bedientaste 42, "Schließen"-Bedientaste 47 und "Anordnen"-Bedientaste 48 wirken jeweils auf das aktive Dialogfenster 41a bis 41c. Sollen alle drei offenen Dialoge der Fig. 4 geschlossen werden, so ist demnach eine dreimalige Betätigung der "Schließen"-Bedientaste 47 erforderlich.

Bei einem Teil der Dialoge kann es zudem sinnvoll sein, zur Erweiterung von Eingabemöglichkeiten für die Einstellparameter die Softkeytasten 37a bis 37f neu zu belegen. In dem Fensterverwaltungsstreifen 35 wird dann durch entsprechende Ikonen die gerade aktuelle Belegung der Softkeytasten 37a bis 37f dargestellt. Um wieder zurück zu der ursprünglichen Belegung der Softkeytasten 37a bis 37f mit den offenen Dialogen zu gelangen, ist eine weitere Hardkey-Bedientaste 49 ("Fensterverwaltung") vorgesehen.

Zusätzlich zu den vorstehend ausgeführten Bedientasten der Frontplatte des Meßgeräts 1, die die Verwaltung der Dialoge und Dialogfenster betreffen, sind auf der Frontplatte ein Tastenfeld 50 zur Eingabe alphanumerischer Werte für die Einstellparameter sowie eine "Abbruch"-Bedientaste 51 vorhanden, mit der z.B. ein Abbruch einer fehlerhaften Werteeingabe möglich ist.

## Patentansprüche

1. Meßgerät (1) mit
mehreren Funktionseinheiten (2a, 2b, 6, 13a, 13b, 15a, 15b, 20a, 20b, 22a, 22b), wobei für zumindest einen Teil der Funktionseinheiten mehrere Einstellparameter einstellbar sind und die Änderung der Einstellparameter über Dialogfenster (41a, 41b, 41c, ...) eingebbar ist, einer Steuereinrichtung (34), die die Einstellung der Einstellparameter steuert, und
einer optischen Darstellungseinrichtung (29), auf der die Dialogfenster (41a, 41b, 41c, ...) darstellbar sind,
wobei jedes neu geöffnete Dialogfenster (41a, 41b, 41c, ...) einer Softkeytaste (37a,..., 37f) zugeordnet ist und die aktuelle Belegung der Softkeytasten (37a,..., 37f) durch eine Ikone (52a, 52b, 52c,...) auf der Darstellungseinrichtung (29) dargestellt ist, mit der das jeweilige Dialogfenster (41a, 41, 41c, ...) in den Vordergrund der Darstellungseinrichtung (29) bringbar ist und in dem Dialogfenster (41a, 41b, 41c, ...) die Bedienelemente (45, 46) derjenigen Funktionen zusammengefaßt dargestellt sind, die den Einstellparametern einer Funktionseinheit (2a, 2b, 6, 13a, 13b, 15a, 15b, 20a, 20b, 22a, 22b) entsprechen,
wobei das jeweils aktuelle Dialogfenster (41c, ...) durch eine weitere bestimmte Bedientaste (47) schließbar ist.

2. Meßgerät nach Anspruch 1,
**dadurch gekennzeichnet,**
**daß** bei vollständiger Belegung aller Softkeytasten (37a, ..., 37f) mit Dialogfenstern (41a, 41b, 41c, ...) bei Öffnen eines weiteren Dialogfensters (41a, 41b, 41c, ...) dasjenige Dialogfenster (41a, 41b, 41c, ...) geschlossen und seine Softkeytaste (37a, ..., 37f) durch das neue Dialogfenster (41a, 41b, 41c, ...) belegt wird, welches am längsten nicht mehr im Vordergrund war.

3. Meßgerät nach Anspruch 1 oder 2,
**dadurch gekennzeichnet,**
**daß** eine Änderung der Einstellparameter einer Funktionseinheit (2a, 2b, 6, 13a, 13b, 15a, 15b, 20a, 20b, 22a, 22b) durch die Steuereinrichtung (34) instantan umgesetzt wird.

4. Meßgerät nach einem der Ansprüche 1 bis 3,
**dadurch gekennzeichnet,**
**daß** ein neues Dialogfenster (41a, 41b, 41c, ...) an einer durch eine Voreinstellung bestimmbaren Position der Darstellungseinrichtung (29) öffnet.

5. Meßgerät nach einem der Ansprüche 1 bis 4,
**dadurch gekennzeichnet,**
**daß** das jeweils aktuelle Dialogfenster (41c, ...) durch eine bestimmte Bedientaste (42) in den Hintergrund bringbar ist.

6. Meßgerät nach einem der Ansprüche 1 bis 5,
**dadurch gekennzeichnet,**
**daß** mehrere Bedienelemente (44, 45, 46) einen Bedienblock bilden, der durch einen Bedienfokus (43) gemeinsam optisch hervorhebbar ist.

7. Meßgerät nach Anspruch 6,
**dadurch gekennzeichnet,**
**daß** bei mehreren Bedienblöcken der Bedienfokus (43) mittels eines Positionierungselements (33, 38) und/oder von Richtungstasten (39) verschiebbar ist.

8. Meßgerät nach Anspruch 6 oder 7,
**dadurch gekennzeichnet,**
**daß** der jeweils aktuell durch den Bedienfokus (43) hervorgehobene Bedienblock durch ein Auswahlmittel (38, 40) selektierbar ist.

9. Verfahren zur Verwaltung von Dialogfenstern (41a, 41b, 41c), über die Einstellparameter von Funktionseinheiten (2a,b, 6, 13a, 15a, 20a, 22a,) eines Meßgeräts (1), eingebbar sind, wobei die Funktionseinheiten (2a,b, 6, 13a, 15a, 20a, 22a,) als Funktionsblöcke (102a, 106, 113a, 115a, 120a, 122a) auf einer Darstellungseinrichtung (29) dargestellt sind, mit folgenden Verfahrensschritten:
- Positionieren einer Markierung (36) an einem Funktionsblock (102a) mittels eines Positionierungselements (33, 38);
- Selektieren des markierten Funktionsblocks (102a) mittels eines Auswahlmittels (38, 40);
- Darstellen von Bedienblöcken, die den Einstellparametern der selektierten Funktionseinheit (102a) entsprechen, in einem zugeordneten Dialogfenster (41a);
- Zuordnen jedes geöffneten Dialogfensters (41a, 41b, 41c, ...) zu einer Softkeytaste (37a,..., 37f); und
- Darstellen einer jeweils ein geöffnetes Dialogfenster (41a, 41b, 41c,...) repräsentierenden Ikone (52a, 52b, 52c, ...) an einer der zugeordneten Softkeytaste (37a,..., 37f) korrespondierenden Position der Darstellungseinrichtung (29),
wobei bei Betätigen einer bestimmten Bedientaste (47) das aktive, im Vordergrund der Darstellungseinrichtung (29) dargestellte Dialogfenster (41c, ...) geschlossen wird.

10. Verfahren nach Anspruch 9,
**dadurch gekennzeichnet,**
**daß** bei Betätigen einer Softkeytaste (37a,..., 37f) das zugeordnete Dialogfenster (41a, 41b, 41c, ...) auf der Darstellungseinrichtung (29) im Vordergrund dargestellt wird.

11. Verfahren nach einem der Ansprüche 9 oder 10,
**dadurch gekennzeichnet,**
**daß** bei Belegung aller verfügbaren Softkeytasten (37a,..., 37f) und Öffnen eines weiteren Dialogfensters (41a, 41b, 41c, ...) dasjenige Dialogfenster (41a, 41b, 41c, ...) geschlossen wird, das am längsten nicht mehr im Vordergrund dargestellt war.

12. Verfahren nach einem der Ansprüche 9 bis 11,
**dadurch gekennzeichnet,**
**daß** bei Betätigen einer bestimmten Bedientaste (42) das aktive, im Vordergrund der Darstellungseinrichtung (29) dargestellte Dialogfenster (41c, ...) in den Hintergrund gebracht wird.

13. Verfahren nach einem der Ansprüche 9 bis 12,
**dadurch gekennzeichnet,**
**daß** bei Betätigen eines Positionierungselements (38) und/oder von Richtungstasten (39) der jeweils dem aktuell durch einen Bedienfokus (43) hervorgehobenen Bedienblock benachbarte Bedienblock durch den Bedienfokus (43) hervorgehoben wird.

14. Verfahren nach Anspruch 13,
**dadurch gekennzeichnet,**
**daß** der aktuell durch den Bedienfokus (43) hervorgehobene Bedienblock durch Betätigen eines Auswahlmittels (38, 40) selektiert wird.

15. Computerprogramm mit Programmcode zur Durchführung aller Verfahrensschritte nach einem der Ansprüche 9 bis 14, wenn das Programm in einem Computer oder einer Steuereinheit (34) eines Meßgeräts (1) ausgeführt wird.

16. Computerprogramm mit Programmcode, der auf einem maschinenlesbaren Träger gespeichert ist, zur Durchführung des Verfahrens nach einem der Ansprüche 9 bis 14, wenn das Programm in einem Computer oder einer Steuereinheit (34) eines Meßgeräts (1) ausgeführt wird.

## Claims

1. A measuring device (1)
with several functional units (2a, 2b, 6, 13a, 13b, 15a, 15b, 20a, 20b, 22a, 22b), wherein several adjustment parameters are adjustable for at least some of the functional units, and wherein changes to the adjustment parameters can be entered via dialog windows (41a, 41b, 41c,...),
with a control device (34), which controls the setting of the adjustment parameters, and
with a visual display device (29), on which the dialog windows (41a, 41b, 41c,...) can be displayed, wherein each newly opened dialog window (41a, 41b, 41c,...) is allocated to a soft key (37a,..., 37f), and the current definition of the soft keys (37a, ..., 37f) is displayed through an icon (52a, 52b, 52c,...) on the display device (29), by means of which the relevant dialog window (41a, 41b, 41c,...) can be moved to the foreground of the display device (29), and wherein the operating elements (45, 46) for those functions which correspond to the adjustment parameters for one functional unit (2a, 2b, 6, 13a, 13b, 15a, 15b, 20a, 20b, 22a, 22b) are displayed together in the dialog window (41a, 41b, 41c,...), wherein the respectively current dialog window (41c, ...) can be closed with a further given operating key (47).

2. The measuring device according to claim 1
**characterised in that,**
in the event of a complete definition of all soft keys (37a,... 37f) with dialog windows (41a, 41b, 41c, ...), if a further dialog window (41a, 41b, 41c,...) is opened, the dialog window (41a, 41b, 41c,...) which has not been moved to the foreground for the longest period is closed, and its soft key (37a,...37f) is defined by the new dialog window (41a, 41b, 41c,...).

3. The measuring device according to claim 1 or 2
**characterised in that,**
a change of the adjustment parameters for a functional unit (2a, 2b, 6, 13a, 13b, 15a, 15b, 20a, 20b, 22a, 22b) is implemented instantaneously by the control device (34).

4. The measuring device according to any one of claims 1 to 3,
**characterised in that,**
a new dialog window (41a, 41b, 41c,...) opens at a position on the display device (29) which can be specified by a preliminary setting.

5. The measuring device according to any one of claims 1 to 4,
**characterised in that,**
the current dialog window (41c,...) in each case can be moved to the background by means of a given operating key (42).

6. The measuring device according to any one of claims 1 to 5,
**characterised in that,**
several operating elements (44, 45, 46) form an operating block which can be visually highlighted by means of an operating focus function (43).

7. The measuring device according to claim 6,
**characterised in that,**
in the case of several operating blocks, the operating focus function (43) can be moved by means of a positioning element (33, 38) and/or by means of direction keys (39).

8. The measuring device according to claim 6 or 7,
**characterised in that,**
the current operating block, which is highlighted in each case by the operating focus function (43), can be selected using a selection means (38, 40).

9. A method for managing dialog windows (41a, 41b, 41c), by means of which adjustment parameters for functional units (2a,b, 6, 13a, 15a, 20a, 22a) of a measuring device (1) can be entered, wherein the functional units (2a,b, 6, 13a, 15a, 20a, 22a) are displayed on a display device (29) as functional blocks (102a, 106, 113a, 115a, 120a, 122a), comprising the following method steps:
- positioning a marker (36) on a functional block (102a) by means of a positioning element (33, 38);
- selecting the marked functional block (102a) using a selection means (38, 40);
- displaying operating blocks which correspond to the adjustment parameters of the selected functional unit (102a) in an allocated dialog window (41a);
- allocating every open dialog window (41a, 41b, 41c,...) to a soft key (37a, ..., 37f); and
- displaying an icon (52a, 52b, 52c,...) representing an open dialog window (41a, 41b, 41c,...) in each case at a position on the display device (29) corresponding to the allocated soft key (37a,..., 37f),
wherein, when a given operating key (47) is activated, the active dialog window (41c, ...) displayed in the foreground of the display device (29) is closed.

10. The method according to claim 9,
**characterised in that,**
when a soft key (37a,...,37f) is activated, the allocated dialog window (41a, 41b, 41c, ...) is displayed in the foreground of the display device (29).

11. The method according to any one of claims 9 or 10,
**characterised in that,**
when all available soft keys (37a, ..., 37f) have been defined, and a further dialog window (41a, 41b, 41c,...) is opened, the dialog window (41a, 41b, 41c,...) which has not been displayed in the foreground for the longest period is closed.

12. The method according to any one of claims 9 to 11,
**characterised in that,**
the active dialog window (41c,...) displayed in the foreground of the display device (29) is moved to the background when a given operating key (42) is activated.

13. The method according to any one of claims 9 to 12,
**characterised in that,**
when a positioning element (38) and/or direction keys (39) are activated, the operating block adjacent to the operating block currently highlighted by means of an operating focus function (43) is highlighted by the operating focus function (43).

14. The method according to claim 13,
**characterised in that,**
the operating block currently highlighted by the operating focus function (43) can be selected by activating a selection means (38, 40).

15. A computer program with program code for implementing all of the procedural steps according to any one of claims 9 to 14 when the program is executed on a computer or a control unit (34) of a measuring device (1).

16. A computer program with program code, which is stored on a machine-readable medium, for implementing the method according to any one of claims 9 to 14 when the program is executed on a computer or a control unit (34) of a measuring device (1).

## Revendications

1. Appareil de mesure (1) comportant
plusieurs unités fonctionnelles (2a, 2b, 6, 13a, 13b, 15a, 15b, 20a, 20b, 22a, 22b), dans lequel plusieurs paramètres de réglage peuvent être déterminés pour au moins une partie des unités fonctionnelles et la modification des paramètres de réglage peut être saisie par l'intermédiaire de fenêtres de dialogue (41a, 41b, 41c,...),
un dispositif de commande (34), qui commande le réglage des paramètres de réglage, et
un dispositif d'affichage optique (29), sur lequel les fenêtres de dialogue (41a, 41b, 41c,...) peuvent être affichées,
dans lequel chaque nouvelle fenêtre de dialogue ouverte (41a, 41b, 41c,...) est associée à une touche (37a,..., 37f) et l'occupation actuelle des touches (37a,...,37f) est affichée par une icône (52a, 52b, 52c,...) sur le dispositif d'affichage (29), grâce à laquelle la fenêtre de dialogue respective (41a, 41, 41c,...) peut être amenée au premier plan du dispositif d'affichage (29) et les éléments de commande (45, 46) de ces fonctions sont affichés de façon résumée dans la fenêtre de dialogue (41a, 41b, 41c,...), qui correspondent aux paramètres de réglage d'une unité fonctionnelle (2a, 2b, 6, 13a, 13b, 15a, 15b, 20a, 20b, 22a, 22b),
dans lequel la fenêtre de dialogue actuelle respective (41c,...) peut être fermée par une autre touche de commande déterminée (47).

2. Appareil de mesure selon la revendication 1, **caractérisé en ce que**
dans le cas d'une occupation complète de toutes les touches (37a,...,37f) par les fenêtres de dialogue (41a, 41b, 41c,...), cette fenêtre de dialogue (41a, 41b, 41c,...), qui n'était plus depuis longtemps au premier plan, est fermée lors de l'ouverture d'une autre fenêtre de dialogue (41a, 41b, 41c,...) et sa touche (37a,...,37f) est occupée par la nouvelle fenêtre de dialogue (41a, 41b, 41c,...).

3. Appareil de mesure selon la revendication 1 ou 2, **caractérisé en ce que**
une modification des paramètres de réglage d'une unité fonctionnelle (2a, 2b, 6, 13a, 13b, 15a, 15b, 20a, 20b, 22a, 22b) est mise en oeuvre par l'unité de commande (34).

4. Appareil de mesure selon l'une des revendications 1 à 3, **caractérisé en ce que**
une nouvelle fenêtre de dialogue (41a, 41b, 41c,...) s'ouvre dans une position du dispositif d'affichage (29) pouvant être déterminée par préréglage.

5. Appareil de mesure selon l'une des revendications 1 à 4, **caractérisé en ce que**
la fenêtre de dialogue actuelle respective (41c,...) peut être amenée à l'arrière-plan par une touche de commande déterminée (42).

6. Appareil de mesure selon l'une des revendications 1 à 5, **caractérisé en ce que**
plusieurs éléments de commande (44, 45, 46) forment un bloc de commande, qui peut être mis en évidence optiquement simultanément par une sélection (43).

7. Appareil de mesure selon la revendication 6, **caractérisé en ce que**
dans le cas de plusieurs blocs de commande, la sélection (43) peut être déplacée au moyen d'un élément de positionnement (33, 38) et/ou des touches de direction.

8. Appareil de mesure selon la revendication 6 ou 7, **caractérisé en ce que**
le bloc de commande actuel respectif mis en évidence par la sélection (43) peut être sélectionné par un moyen de sélection (38, 40).

9. Procédé pour gérer des fenêtres de dialogue (41a, 41b, 41c) grâce auquel des paramètres de réglage d'unités fonctionnelles (2a,b, 6, 13a, 15a, 20a, 22a) d'un appareil de mesure (1) peuvent être saisis, dans lequel les unités fonctionnelles (2a,b, 6, 13a, 15a, 20a, 22a) sont affichées en tant que blocs fonctionnels (102a, 106, 113a, 115a, 120a, 122a) sur un dispositif d'affichage (29), comportant les étapes de procédé suivantes :
- le positionnement d'un repère dans un bloc fonctionnel (102a) au moyen d'un élément de positionnement (33, 38) ;
- la sélection du bloc fonctionnel repéré (102a) grâce à un moyen de sélection (38, 40) ;
- l'affichage des blocs de commande, qui correspondent aux paramètres de réglage de l'unité fonctionnelle sélectionnée (102a), dans une fenêtre de dialogue associée (41a) ;
- l'association de chaque fenêtre de dialogue ouverte (41a, 41b, 41c,...) à une touche (37a,...,37f) ; et
- l'affichage d'une icône (52a, 52b, 52c,...) représentant respectivement une fenêtre de dialogue ouverte (41a, 41b, 41c,...) à une position correspondante à la touche associée (37a,...,37f) du dispositif d'affichage (29),
dans lequel la fenêtre de dialogue (41c,...) représentée au premier plan du dispositif d'affichage (29) est fermée par activation d'une touche de commande déterminée (47).

10. Procédé selon la revendication 9, **caractérisé en ce que**
la fenêtre de dialogue associée (41a, 41b, 41c,...) est affichée au premier plan sur le dispositif d'affichage (29) lors de l'activation d'une touche (37a,...,37f).

11. Procédé selon l'une des revendications 9 ou 10, **caractérisé en ce que**
dans le cas de l'occupation de toutes les touches disponibles (37a,...,37f) et de l'ouverture d'une nouvelle fenêtre de dialogue (41a, 41b, 41c,...), cette fenêtre de dialogue (41a, 41b, 41c,...), qui n'était plus affichée au premier plan depuis longtemps, est fermée.

12. Procédé selon l'une des revendications 9 à 11, **caractérisé en ce que**
la fenêtre de dialogue (41c,...) active représentée au premier plan du dispositif d'affichage (29) est amenée à l'arrière-plan par activation d'une touche de commande déterminée (42).

13. Procédé selon l'une des revendications 9 à 12, **caractérisé en ce que**
le bloc de commande respectif voisin du bloc de commande actuel sélectionné par une sélection (43) est mis en évidence par la sélection (43) lors de l'actionnement d'un élément de positionnement (38) et/ou des touches de direction (39).

14. Procédé selon la revendication 13, **caractérisé en ce que**
le bloc de commande actuel mis en évidence par la sélection (43) est sélectionné par actionnant d'un moyen de sélection (38, 40).

15. Programme informatique comportant un code de programme pour mettre en oeuvre toutes les étapes de procédé selon l'une des revendications 9 à 14, lorsque le programme est exécuté dans un ordinateur ou une unité de commande (34) d'un appareil de mesure (1).

16. Programme informatique comportant un code de programme, qui est mémorisé sur un support pouvant être lu par une machine, pour mettre en oeuvre le procédé selon l'une des revendications 9 à 14, lorsque le programme est exécuté dans un ordinateur ou une unité de commande (34) d'un appareil de mesure (1).
